# EUROPEAN PATENT APPLICATION

(11) **EP 2 099 130 A1**
(43) Date of publication of application: **09.09.2009**
(21) Application number: 07829183.8
(22) Date of filing: 04.10.2007
(51) Int. Cl.: H03H 9/64, H03H 9/145

(54) **SURFACE ACOUSTIC WAVE FILTER DEVICE**

(30) Priority: 07.12.2006 JP 2006330470
(71) Applicant: Murata Manufacturing Co. Ltd., Nagaokakyo-shi, Kyoto 617-8555 (JP)
(72) Inventor: WATANABE, Norio, Nagaokakyo-shi Kyoto 617-8555 (JP)
(74) Representative: Thévenet, Jean-Bruno
(86) International application number: PCT/JP2007/069445
(87) International publication number: WO 2008/068951

(57) **Abstract**

A cascaded longitudinally coupled resonator-type surface acoustic wave filter device including an inter-stage capacitor is miniaturized. A first and a second longitudinally coupled resonator-type surface acoustic wave filter (3 and 4) are disposed on a piezoelectric substrate (2). One end of a first IDT (3a) arranged at the middle of the first longitudinally coupled resonator-type surface acoustic wave filter is connected to a first unbalanced terminal (5), and one end of a first IDT (4a) arranged at the middle of the second longitudinally coupled resonator-type surface acoustic wave filter is connected to a second unbalanced terminal (6). Signal terminals of second IDTs (3b and 4b) of the first and the second longitudinally coupled resonator-type surface acoustic wave filter (3 and 4) are connected to each other with a first signal line (9). Third IDTs (3c and 4c) are connected to each other with a second signal line (10). A capacitor (11) is connected between the first and the second signal line (9 and 10).

## Description

### Technical Field

The present invention relates to longitudinally coupled resonator-type surface acoustic wave filter devices, and more particularly to a surface acoustic wave filter device including a first and a second longitudinally coupled resonator-type surface acoustic wave filter that are connected in a cascade arrangement on a piezoelectric substrate.

### Background Art

In general, a longitudinally coupled resonator-type surface acoustic wave filter device is widely used as the RF stage band-pass filter of cellular phones. When a large attenuation is required outside the pass band for a longitudinally coupled resonator-type surface acoustic wave filter device, a structure is often employed in which a plurality of longitudinally coupled resonator-type surface acoustic wave filters are connected in a cascade arrangement.

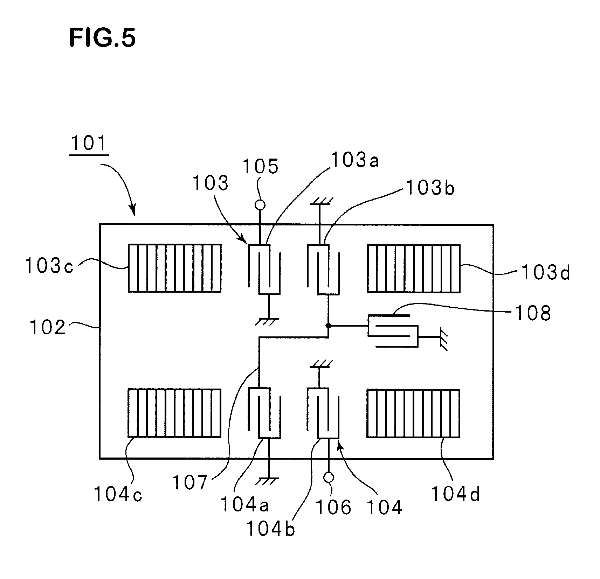

For example, the below listed Patent Document 1 discloses a two-stage cascaded longitudinally coupled resonator-type surface acoustic wave filter device as shown in Fig. 5.

The longitudinally coupled resonator-type surface acoustic wave filter device 101 shown in Fig. 5 has an electrode structure schematically shown in Fig. 5 on a piezoelectric substrate 102. The piezoelectric substrate 102 is made of a 36° Y-cut X-propagating LiTaO₃. A first longitudinally coupled resonator-type surface acoustic wave filter 103 and a second longitudinally coupled resonator-type surface acoustic wave filter 104 are connected in a cascade arrangement on the piezoelectric substrate 102. The longitudinally coupled resonator-type surface acoustic wave filter 103 includes a first and a second IDT 103a and 103b disposed with a distance therebetween in the surface acoustic wave propagating direction. Reflectors 103c and 103d are disposed at the sides of the IDTs 103a and 103b in the surface wave propagating direction. The second longitudinally coupled resonator-type surface acoustic wave filer 104 also includes a first and a second IDT 104a and 104b, and reflectors 104c and 104d disposed at the sides of the IDTs 104a and 104b in the surface wave propagating direction.

One end of the first IDT 103a of the first longitudinally coupled resonator-type surface acoustic wave filter 103 is connected to an input terminal 105 and the other end is connected to the ground potential. One end of the second IDT 103b is connected to the ground potential and the other end is connected to the first IDT 104a of the second longitudinally coupled resonator-type surface acoustic wave filter 104 with a signal line 107. One end of the IDT 104a is connected to the signal line 107 and the other end is connected to the ground potential. One end of the second IDT 104b of the second longitudinally coupled resonator-type surface acoustic wave filter 104 is connected to the ground potential and the other end is connected to an output terminal 106.

In the longitudinally coupled resonator-type surface acoustic wave filter device 101, a comb-like electrode 108 is connected between the signal line 107 and the ground potential. According to Patent Document 1, the comb-like electrode 108 is intended to provide a capacitance between the signal line 107 for inter-stage connection and the ground potential, thereby suppressing spurious responses in the pass band.
Patent Document 1: Japanese Unexamined Patent Application Publication 7-74588

### Disclosure of Invention

In order to provide a capacitance sufficient to reduce spurious responses in the longitudinally coupled resonator-type surface acoustic wave filter device 101, however, a relatively large comb-like electrode 108 is required. This often restricts the electrode structure of the surface acoustic wave filters 103 and 104 on the piezoelectric substrate 102, and the formation area of the wirings with connection to the signal line 107 and the ground potential.

Accordingly, the surface acoustic wave filter device must be large, and this hinders miniaturization. Since the layout of the electrodes and wires are restricted, it is difficult to improve the performance by the modification of the layout.

Accordingly, a purpose of the invention is to provide a longitudinally coupled resonator-type surface acoustic wave filter device having a structure allowing the miniaturization and the reduction of spurious responses within the pass band, and enhancing the design flexibility of the electrode structure and the wiring layout on the piezoelectric substrate.

The preset invention provides a surface acoustic wave filter device including a piezoelectric substrate and a first and a second longitudinally coupled resonator-type surface acoustic wave filter disposed on the piezoelectric substrate. Each longitudinally coupled resonator-type surface acoustic wave filter includes a first IDT, a second and a third IDT respectively disposed to both sides of the first IDT in the surface acoustic wave propagating direction, and a pair of reflectors disposed at both sides in the surface wave propagating direction of the area on which the first to third IDTs are disposed. A first signal line is disposed to connect a signal terminal of the second IDT of the first longitudinally coupled resonator-type surface acoustic wave filter and a signal terminal of the second IDT of the second longitudinally coupled resonator-type surface acoustic wave filter to each other. A second signal line is disposed to connect a signal terminal of the third IDT of the first longitudinally coupled resonator-type surface acoustic wave filter and a signal terminal of the third IDT of the second longitudinally coupled resonator-type surface acoustic wave filter to each other. In addition, at least one capacitor is connected between the first and the second signal line. The phase of the electrical signal transmitted through the first signal line is 180° different from the phase of the electrical signal transmitted through the second signal line.

Preferably, the capacitor is a comb-like electrode formed on the piezoelectric substrate. The comb-like electrode is small, but can provide a large capacitance. Accordingly, the surface acoustic wave filter device can be miniaturized.

Preferably, the first IDTs of the first and the second longitudinally coupled resonator-type surface acoustic wave filter are connected to a first and a second unbalanced signal terminal, respectively. This structure provides a small unbalanced input/output band-pass filter not affected by spurious responses within the pass band, exhibiting superior characteristics.

### (Advantages)

In the surface acoustic wave filter device of the present invention, a first and a second longitudinally coupled resonator-type surface acoustic wave filter each having first to third IDTs are connected in a cascade arrangement by connecting the signal terminals of their second IDTs to each other with a first signal line, and connecting the signal terminals of their third IDTs to each other with a second signal line. In addition, at least one capacitor is connected between the first and the second signal line to provide a capacitance between stages. Thus, spurious responses in the pass band are reduced. In the surface acoustic wave filter device disclosed in Patent Document 1, an inter-stage capacitor is connected between a signal line and the ground potential. Consequently, a large comb-like electrode must be disposed to sufficiently reduce spurious responses. On the other hand, in the present invention, the capacitor is disposed between the first and the second signal line. This arrangement can reduce the size of the capacitor required to sufficiently reduce spurious responses.

Since a smaller capacitor can improve the performance of the filter, the surface acoustic wave filter device can be miniaturized and the design flexibility of the layout of the electrodes and wiring lines on the piezoelectric substrate can be enhanced. Accordingly, the performance can be enhanced by modifying the layout of the electrodes and the wiring lines, and thereby, a small, high-performance surface acoustic wave filter can be provided.

### Brief Description of Drawings

[Fig. 1] Fig. 1 is a schematic plan view of a surface acoustic wave filter device according to an embodiment of the invention.
[Fig. 2] Fig. 2 is a schematic plan view of a surface acoustic wave filter device prepared for comparison.
[Fig. 3] Fig. 3 is a representation of attenuation/frequency characteristics of a surface acoustic wave filter device of the embodiment shown in Fig. 1 and the surface acoustic wave filter device prepared for comparison.
[Fig. 4] Fig. 4 shows attenuation/frequency characteristics of the surface acoustic wave filter devices of the embodiment shown in Fig. 1 and prepared for comparison.
[Fig. 5] Fig. 5 is a schematic plan view of a known surface acoustic wave filter device.

### Reference Numerals

- 1: surface acoustic wave filter device
- 2: piezoelectric substrate
- 3: first longitudinally coupled resonator-type surface acoustic wave filter
- 3a-3c: first to third IDT
- 3d, 3e: reflector
- 4: second longitudinally coupled resonator-type surface acoustic wave filter
- 4a-4c: first to third IDT
- 4d, 4e: reflector
- 5: first unbalanced terminal
- 6: second unbalanced terminal
- 7, 8: ground line
- 9, 10: first/second signal line
- 11: comb-like electrode

### Best Mode for Carrying Out the Invention

The present invention will further be described in detail below, using a specific embodiment with reference to the drawings.

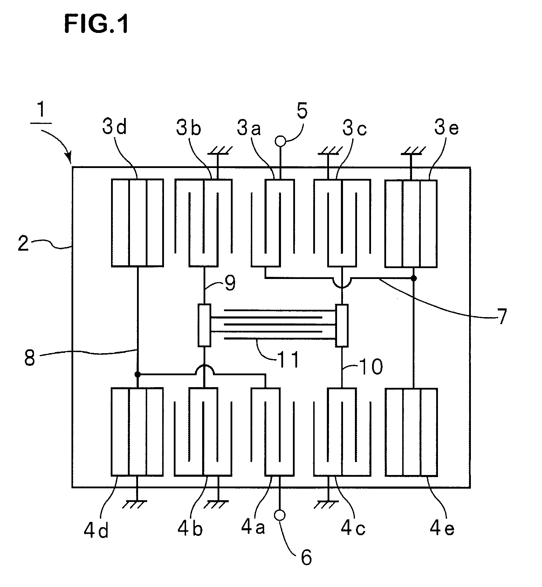

Fig. 1 is a schematic plan view a surface acoustic wave filter device according to a first embodiment of the invention.

The surface acoustic wave filter device 1 includes a piezoelectric substrate 2. The piezoelectric substrate 2 is made of LiTaO₃ in the present embodiment. The piezoelectric substrate 2, however, may be a LiTaO₃ substrate having a different cut angle, or may be made of other piezoelectric single crystal, such as LiNbO₃ or quartz, or piezoelectric ceramic.

An electrode structure and wiring lines, which are schematically shown in the figure, are formed on the piezoelectric substrate 2.

More specifically, a first longitudinally coupled resonator-type surface acoustic wave filter 3 and a second longitudinally coupled resonator-type surface acoustic wave filter 4 are disposed on the piezoelectric substrate 2. The first longitudinally coupled resonator-type surface acoustic wave filter 3 includes a first IDT 3a, and a second and a third IDT 3b and 3c respectively disposed at both sides of the first IDT 3a in the surface wave propagating direction. Also, reflectors 3d and 3e are disposed at both sides in the surface wave propagating direction of the area to which the first to third IDTs 3a to 3c are disposed.

The second longitudinally coupled resonator-type surface acoustic wave filter 4 also includes a first IDT 4a, and a second and a third IDT 4b and 4c respectively disposed at both sides of the first IDT 4a in the surface wave propagating direction. Also, reflectors 4d and 4e are disposed at both sides in the surface wave propagating direction of the area in which the IDTs 4a to 4c are disposed. One end of the first IDT 3a is connected to a first unbalanced terminal 5 that is one of input/output terminals. The other end of the IDT 3a is connected to a ground line 7. The ground line 7 connects the IDT 3a to the reflector 3e, and the reflector 3e is connected to the ground potential. Hence, that other end of the IDT 3a is connected to the ground potential.

The ground line 7 is also connected to the reflector 4e, and the reflector 4e is thus connected to the ground potential.

One end of the second IDT 3b is connected to the ground potential, and the other end is connected to a first signal line 9. That other end of the second IDT 3b and one end of the second IDT 4b of the second longitudinally coupled resonator-type surface acoustic wave filter 4 are connected to each other with the first signal line 9. The other end of the second IDT 4b is connected to the ground potential. In other words, the signal terminal of the second IDT 3b and the signal terminal of the second IDT 4b are electrically connected to each other with the first signal line 9.

Similarly, one end of the third IDT 3c is connected to the ground potential, and the other end, or signal terminal, is connected to a second signal line 10. The second signal line 10 is connected to one end, or signal terminal, of the third IDT 4c. The other end of the third IDT 4c is connected to the ground potential. One end of the first IDT 4a is connected to a second unbalanced terminal 6 that is the other of the input/output terminals, and the other end is connected to a ground line 8. The ground line 8 is electrically connected to that other end of the IDT 4a, and the reflectors 3d and 4d. The reflector 4d is connected to the ground potential. Hence, the terminal of the IDT 4a opposite to the end connected to the unbalanced terminal 6 is connected to the ground potential.

The phase of the signal transmitted through the first signal line 9 is 180° different from that of the signal transmitted through the second signal line. Hence, the first signal line 9 and the second signal line 10 are balanced signal lines. However, the first IDTs 3a and 4a each have an even number of electrode fingers, and the second and the third IDTs 3b, 3c, 4b and 4c each have an odd number of electrode fingers. Thus, the surface acoustic wave filter device 1 has an unbalanced input-unbalanced output structure.

As long as the first and the second signal line 9 and 10 are balanced, for example, the first to third IDTs 3a, 4a, 3b, 3c, 4b and 4c each may have an even number of electrode fingers with the second IDTs 3b and 4b disposed in opposite orientation to the third IDTs 3c and 4c.

The feature of the surface acoustic wave filter device 1 of the present embodiment is that a capacitor defined by a comb-like electrode 11 is connected between the first and the second signal line 9 and 10. Although the structure in which the first and the second longitudinally coupled resonator-type surface acoustic wave filter 3 and 4 are connected in a cascade arrangement causes spurious responses in the pass band, the spurious responses can be suppressed by the comb-like electrode 11 providing a capacitance between stages.

In addition, the structure in which the comb-like electrode 11 provides a capacitance can suppress spurious responses to the same extent as the known surface acoustic wave filter device 101 even though the capacitor is smaller than the comb-like electrode 108 of the known surface acoustic wave filter device 101. Since the performance can be improved with a smaller comb-like electrode 11, the surface acoustic wave filter device 1 can be miniaturized. Since the comb-like electrode 11 can be miniaturized, the electrode structure of the longitudinally coupled resonator-type surface acoustic wave filters 3 and 4, and the layout of the signal lines 9 and 10, the ground lines 7 and 8, and the wiring for connecting the IDTs 3b, 3c, 4b and 4c and the reflectors 3e and 4d to the ground potential can be more flexibly designed on the piezoelectric substrate 2. Accordingly, the performance of the filter device can easily be improved by modifying the electrode structure or the wiring layout.

The material of the electrode structure and the wiring lines can be arbitrarily selected from metals and alloys as desired without particular limitation. The electrode structure or the wiring lines may be made of a multilayer metal film including a plurality of metal layers.

It will now be shown that the surface acoustic wave filter device 1 of the present embodiment with a smaller capacitor can enhance the performance, with reference to a specific experimental example.

A surface acoustic wave filter device 1 was prepared according to the following specifications.

Number of pairs of the electrode fingers of the first IDTs 3a and 4a: 25.5 pairs each
Number of pairs of the electrode fingers of the second and the third IDTs 3b, 3c, 4b and 4c: 15 pairs each
Number of electrode fingers of the reflectors 3d, 3e, 4d and 4e: 54 each
The overlap of the IDTs 3a to 3c and 4a to 4c was set at 19λ, where λ represents the wavelength determined by the pitch of the electrode fingers of the IDTs 3a to 3c. The duty ratios of the IDTs 3a to 3c and 4a to 4c and the reflectors 3d, 3e, 4d and 4e were each set at 0.55. The thickness of the electrodes of the IDT and the reflector was set at 0.03λ.

Capacitance of the comb-like electrode 11: 2.5 pF
The comb-like electrode 11 has 12 pairs of electrode fingers, and the overlap of the electrode fingers was 330 µm. In this instance, the comb-like electrode 11 occupied an area of 330 µm × 70 µm = 23100 µm² on the piezoelectric substrate 2.

In the present embodiment, in order to transmit balanced signals through the signal lines 9 and 10, the middle IDT, or first IDT, had 25.5 pairs of electrode fingers, that is, an even number of, 52, electrode fingers, and the outer IDTs, or the second and the third IDT 3b, 3c, 4b and 4c, each have an odd number of, 31, electrode fingers.

The piezoelectric substrate 2 was made of LiTaO₃, and the electrodes and the wiring pattern were made of Al.

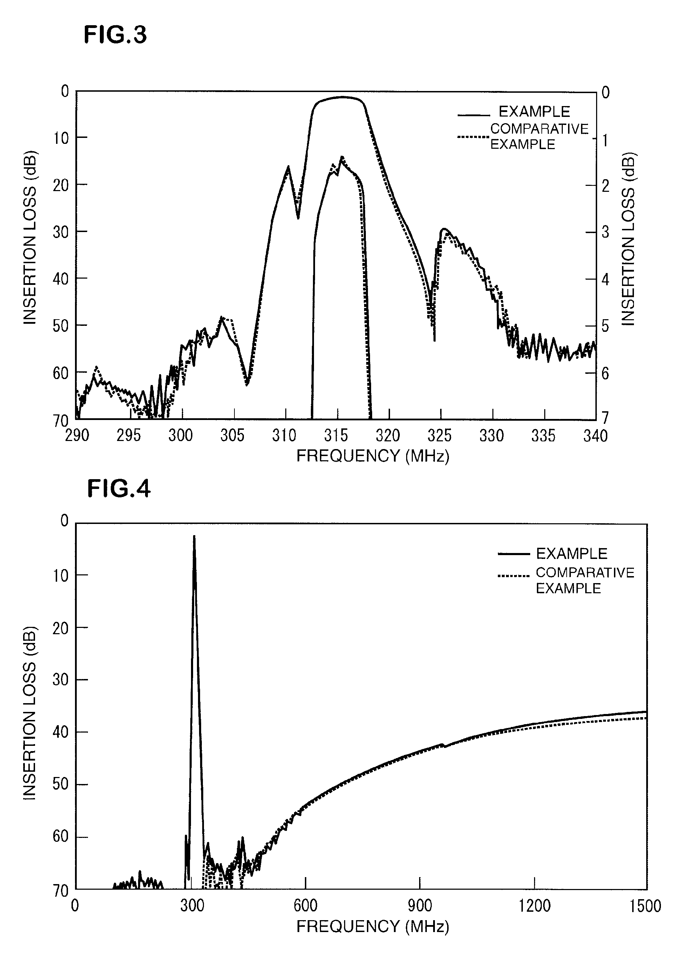

The attenuation/frequency characteristic of the surface acoustic wave filter device 1 prepared according to the above specifications was shown in solid line in Figs. 3 and 4. Fig. 4 shows attenuation/frequency characteristics in the frequency range of 0 to 1500 MHz. Fig. 3 shows part of the attenuation/frequency characteristics in the range of 290 to 340 MHz, and further shows the main portion of the pass band in an enlarged scale using the right axis.

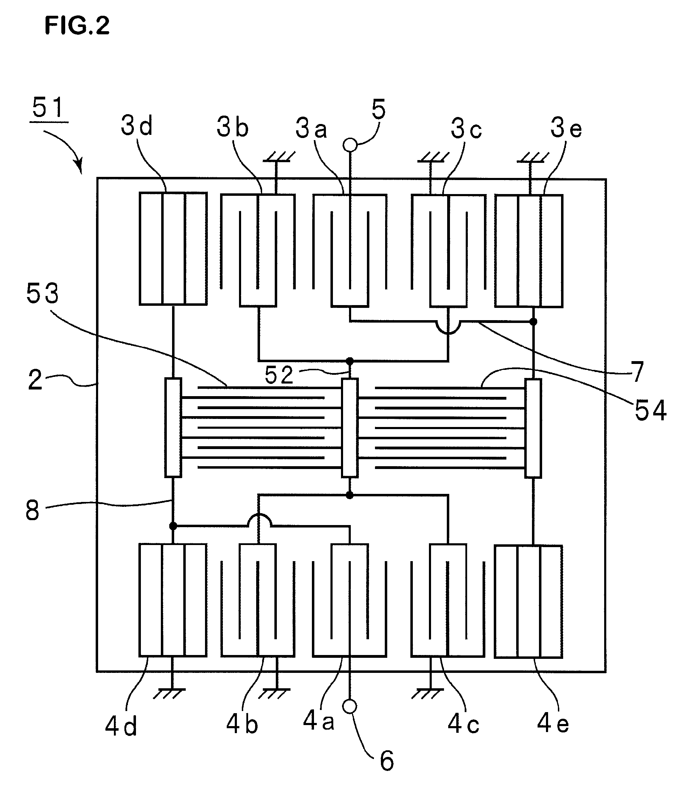

For comparison, a surface acoustic wave filter device 51 shown in Fig. 2 was prepared. This surface acoustic wave filter device 51 has the same structure as the above-described surface acoustic wave filter device 1, except for the connection between the longitudinally coupled resonator-type surface acoustic wave filters 3 and 4 and the electrode defining the inter-stage capacitor. More specifically, one ends of the second and the third IDT 3b and 3c of the first longitudinally coupled resonator-type surface acoustic wave filter 3 are connected together to a signal line 52, as shown in Fig. 2. Similarly, one ends of the second and the third IDT 4b and 4c of the second longitudinally coupled resonator-type surface acoustic wave filter 4 are connected together to the signal line 52. Thus, the signal line 52 connects the first and the second longitudinally coupled resonator-type surface acoustic wave filter 3 and 4. On the other hand, comb-like electrodes 53 and 54 are connected between the signal line 52 and the ground lines 7 and 8. Thus, the comb-like electrodes 53 and 54 are each connected between a signal line and the ground potential between the stages.

In the surface acoustic wave filter device 51 shown in Fig. 2, the overlap of the electrode fingers of the comb-like electrodes 53 and 54 and the number of pairs of the electrode fingers were adjusted so as to control the spurious responses in the pass band as in the above example, that is, so as to have the same filter characteristics. As a result, when the comb-like electrodes 53 and 54 each had 12 pairs of electrode fingers with an overlap of 660 µm, the characteristics indicated by broken lines in Figs. 3 and 4 were obtained. In this instance, the comb-like electrodes 53 and 54 occupied an area of 660 µm × 70 µm × 2 =92400 µm².

The filter characteristics indicated by solid lines and broken lines shown in Figs. 3 and 4 are substantially the same and do not show large spurious responses in the pass band. However, the comb-like electrodes 53 and 54 of the surface acoustic wave filter device 51 of the comparative example occupies a large area of 92400 µm², while the comb-like electrode 11 of the surface acoustic wave filter device 1 of the example occupies an area of 23100 µm². Thus, the embodiment of the invention not only allows the inter-stage capacitor to reduce spurious responses in the pass band, but also allows the miniaturization of the comb-like electrode 11 defining the inter-stage capacitor, thus miniaturizing the surface acoustic wave filter device 11.

Since the area of the region where the comb-like electrode 11 is disposed can be reduced, for example, an electrode pad connected to the ground potential can be provided around the comb-like electrode 11. Accordingly, the design flexibility of the layout of the electrodes including the electrode pad and the wiring lines is increased, and thus the characteristics outside the pass band can be improved.

While in the surface acoustic wave filter device 1 of the above embodiment, the comb-like electrode 11 defines an inter-stage capacitor, other structures may provide a capacitance between the stages. Structures used as the inter-stage capacitor may be such that linear electrodes oppose each other with a predetermined distance on the piezoelectric substrate 2, or such that a pair of electrodes is separated by a dielectric layer formed on the piezoelectric substrate 2. However, the structure using the comb-like electrode 11 can provide a sufficient capacitance using a small area, and is thus most preferable for further miniaturization.

While the above embodiment describes a two-stage cascaded surface acoustic wave filter device in which the first and the second longitudinally coupled resonator-type surface acoustic wave filter 3 and 4 are connected in a cascade arrangement, the present invention can be applied to surface acoustic wave filter devices having three or more stages.

The longitudinally coupled resonator-type surface acoustic wave filter may have five IDTs including a fourth and a fifth IDT disposed at both sides of, for example, the second and third IDTs in the surface wave propagating direction, instead of the three-IDT type having the first to third IDTs. In such a structure, one ends of the fourth and the fifth IDT can be connected together to the terminal of the first IDT connected to an unbalanced terminal, and the other ends can be connected to the ground potential.

## Claims

1. A surface acoustic wave filter device comprising:
a piezoelectric substrate;
a first and a second longitudinally coupled resonator-type surface acoustic wave filter disposed on the piezoelectric substrate, each longitudinally coupled resonator-type surface acoustic wave filter including a first IDT, a second and a third IDT respectively disposed at both sides of the first IDT in the surface acoustic wave propagating direction, and a pair of reflectors disposed at both sides in the surface wave propagating direction of the area in which the first to third IDTs are disposed;
a first signal line connecting a signal terminal of the second IDT of the first longitudinally coupled resonator-type surface acoustic wave filter and a signal terminal of the second IDT of the second longitudinally coupled resonator-type surface acoustic wave filter to each other;
a second signal line connecting a signal terminal of the third IDT of the first longitudinally coupled resonator-type surface acoustic wave filter and a signal terminal of the third IDT of the second longitudinally coupled resonator-type surface acoustic wave filter to each other; and
at least one capacitor connected between the first and the second signal lines,
wherein the phase of the electrical signal transmitted through the first signal line is 180° different from the phase of the electrical signal transmitted through the second signal line.

2. The surface acoustic wave filter device according to Claim 1, wherein the capacitor is a comb-like electrode formed on the piezoelectric substrate.

3. The surface acoustic wave filter device according to Claim 1 or 2, wherein the first IDTs of the first and the second longitudinally coupled resonator-type surface acoustic wave filter are connected to a first and a second unbalanced terminal, respectively.
